# EUROPEAN PATENT SPECIFICATION

(11) **EP 4 005 097 B1**
(45) Date of publication and mention of the grant of the patent: **21.08.2024**
(21) Application number: 21743857.1
(22) Date of filing: 13.01.2021
(51) Int. Cl.: H04B 1/10, H04B 1/12, H03F 3/189, H04L 27/14

(54) **RECEIVER CIRCUITS WITH BLOCKER ATTENUATING RF FILTER**
EMPFÄNGERSCHALTUNGEN MIT EINEM BLOCKERDÄMPFENDEN RF-FILTER
CIRCUITS DE RÉCEPTEUR COMPRENANT UN FILTRE RF D'ATTÉNUATION DE BLOCAGE

(30) Priority: 23.01.2020 US 202016749996
(43) Date of publication of application: 01.06.2022
(73) Proprietor: Shenzhen Goodix Technology Co., Ltd., Shenzhen, Guangdong 518045 (CN)
(72) Inventor: ABOUDINA, Mohamed, San Diego, California 92121 (US); EMIRA, Ahmed, San Diego, California 92121 (US); BABAKRPUR NALOUSI, Esmail, San Diego, California 92121 (US)
(74) Representative: Herrero & Asociados, S.L.
(86) International application number: PCT/CN2021/071598
(87) International publication number: WO 2021/147743

(56) References cited:
- EP-A1- 2 624 463
- EP-A2- 0 913 934
- WO-A1-2011/066474
- WO-A1-98/19477
- CN-A- 1 266 554
- CN-A- 101 521 520
- CN-A- 101 931 382
- CN-A- 106 982 040
- CN-A- 110 268 774
- CN-A- 110 268 774
- US-A1- 2013 115 904
- US-B1- 10 873 486

## Description

### FIELD

The present application generally pertains to receiver circuits, and more particularly to receiver circuits which attenuate blocker signals.

### BACKGROUND

High power signals near the signal frequency are problematic for receivers, as they make it difficult for the receiver to correctly receive the transmitted signal information. Circuit techniques for attenuating blocker signals are needed in the art.

WO9819477A1 discloses a circuit for at least substantially eliminating at least one external interference signal from a radio communication signal received by a code division access (CDMA) mobile phone including a receiving terminal and a low noise amplifier. The circuit comprises: a plurality of damping devices operatively coupled between the receiving terminal and the low noise amplifier; a polarity of switches respectively operatively coupled between the plurality of damping devices and the receiving terminal; an interference detector operatively coupled to the receiving terminal for detecting the at least one external interference signal from the received radio communications signal; and a switch driver operatively coupled between the plurality of switches and the interference detector, the switch generating a switching signal in response to the interference detector to select at least one of the switches in accordance with the at least one detected interference signal in order to vary a gain associated with the received communications signal in accordance with at least one of the damping devices.

EP2624463A1 provides a down-conversion circuit (30) for a receiver circuit (10). It comprises a first mixer (70) arranged to down-convert an RF signal with a first LO signal (LO1), thereby generating a first down-converted signal. It further comprises a second mixer (80) arranged to down-convert the RF signal with a second LO signal (LO2) having the same LO frequency as the first LO signal (LO1), but a different and a second duty cycle, thereby generating a second down-converted signal. The second mixer (80) has an enabled and a disabled mode. The down-conversion circuit (30) also comprises a third mixer (140) arranged to down-convert the RF signal with the second LO signal (LO2), thereby generating a third down-converted signal. A passive output combiner network is used to combine the first and the second down-converted signals such that harmonically down-converted signal content present in the first down-converted signal and harmonically down-converted signal content present in the second down-converted signal cancel in a combined output signal of the down-conversion circuit.

EP0913934A2 discloses a receiving apparatus which can cope with the fluctuation of input level of RF signal appropriately and has a first amplifier means (13) wherein the amplifying and the attenuating of input signal are selectively performed and for processing the signal in a communication band handled by this apparatus, and a second amplifier means (18) for gain-variably amplifying a signal which is a signal converted from the output of the first amplification means 13 into the intermediate frequency signal or base band signal, the gain of the second amplifier means (18) being set based on the detection of output level of the second amplifier means (18), and the selection of the amplification or attenuation in the first amplifier means (13) being performed based on the detection level of output from the first amplifier means (13).

US2013/0115904A1 discloses method for detect interference, which involves detecting the interference component in the received signal if there is such a component, controlling a band reject filter according to the detected interference component to filter the received signal to suppress the interference component, and synchronizing the receiver to the received signal, wherein the step of detecting the interference component is started before synchronization is achieved. By starting the interference detection without waiting for synchronization to be achieved, rather than following the synchronization, then the interference detection is no longer dependent on the synchronization being achieved.

### BRIEF SUMMARY

The invention is set out in the appended set of claims.

### BRIEF DESCRIPTION OF THE DRAWINGS

Figure 1 is a schematic diagram of an embodiment of a receiver circuit.
Figure 2 is a schematic diagram of another embodiment of a receiver circuit.
Figure 3 is a schematic diagram of yet another embodiment of a receiver circuit.

### DETAILED DESCRIPTION

Particular embodiments of the invention are illustrated herein in conjunction with the drawings.

Various details are set forth herein as they relate to certain embodiments. However, the invention can also be implemented in ways which are different from those described herein. Modifications can be made to the discussed embodiments by those skilled in the art without departing from the invention. Therefore, the invention is not limited to particular embodiments disclosed herein.

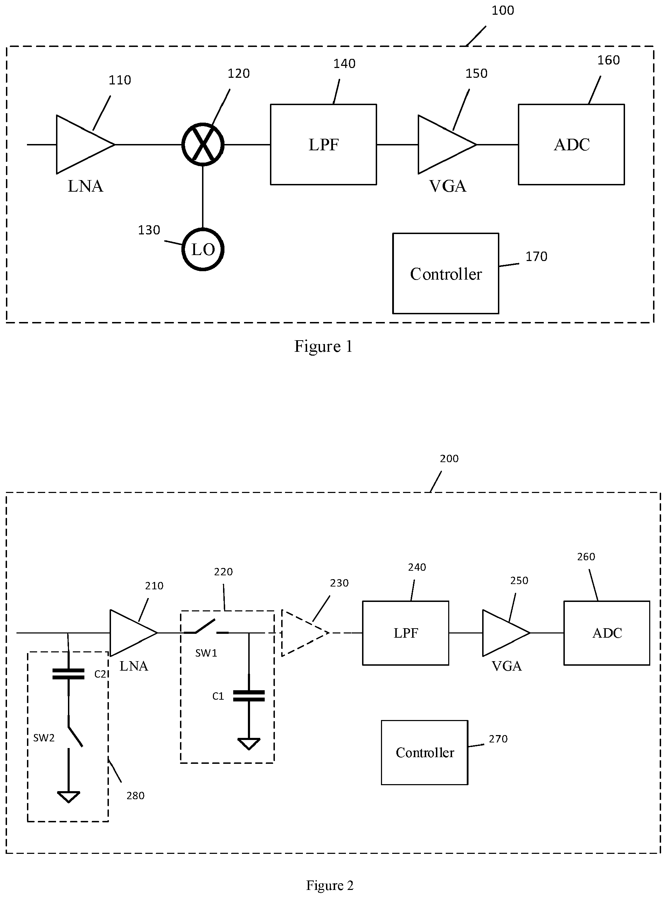

Figure 1 is a schematic diagram of an embodiment of a receiver circuit 100. Receiver circuit 100 includes low noise amplifier (LNA) 110, mixer 120 which receives an oscillator signal from oscillator 130, low-pass filter (LPF) 140, variable gain amplifier (VGA) 150, analog-to-digital converter (ADC) 160, and controller 170.

Low noise amplifier 110 is configured to receive a high-frequency carrier signal modulated with a low frequency information signal. The received signal may also include a blocker signal, such as a high power signal also modulating the high-frequency carrier signal near the frequency of the information signal. Low noise amplifier 110 may be any low noise amplifier or amplifier, as understood by those of skill in the art.

In response to the output from the low noise amplifier 110 and the oscillator signal, mixer 120 down converts the signal from the low noise amplifier 110. The resulting baseband signal includes information of the low frequency information signal and of the blocker signal.

The baseband signal is then processed by the low-pass filter 140. Because of the blocker signal, signals at the low-pass filter 140 may exceed an input or output range limit, such that signals at the input, the output, or internal to the low-pass filter 140 experience clipping, as understood by those of skill in the art. Not being part of the present invention, using techniques known to those of skill in the art, the clipping may be detected, and communicated to controller 170. In response to the detected clipping, controller 170 may generate control signals for low-pass filter 140 to attenuate the baseband signal such that the signal range limit is no longer exceeded, and the clipping stops.

In some embodiments, the low-pass filter 140 does not detect whether the baseband signal exceeds a signal range limit.

The baseband signal is then processed by the variable gain amplifier 150. Because of the blocker signal, signals at the variable gain amplifier 150 may exceed an input or output range limit, such that signals at the input, the output, or internal to the variable gain amplifier 150 experience clipping. Using techniques known to those of skill in the art, the clipping may be detected, and communicated to controller 170. In response to the detected clipping, controller 170 may generate control signals for variable gain amplifier 150 to attenuate the baseband signal such that the signal range limit is no longer exceeded, and the clipping stops. Additionally or alternatively, in response to the detected clipping, controller 170 may generate control signals for low-pass filter 140 to attenuate the baseband signal such that the signal range limit is no longer exceeded, and the clipping stops.

In some embodiments, variable gain amplifier 150 does not detect whether the baseband signal exceeds a signal range limit.

The baseband signal is then processed by the analog-to-digital converter 160. Because of the blocker signal, signals at the analog-to-digital converter 160 may exceed an input or output range limit, such that signals at the input, the output, or internal to the analog-to-digital converter 160 experience clipping. Using techniques known to those of skill in the art, the clipping may be detected, and communicated to controller 170. In response to the detected clipping, controller 170 may generate control signals for analog-to-digital converter 160 to attenuate the baseband signal such that the signal range limit is no longer exceeded, and the clipping stops. Additionally or alternatively, in response to the detected clipping, controller 170 may generate control signals for variable gain amplifier 150 to attenuate the baseband signal such that the signal range limit is no longer exceeded, and the clipping stops. Additionally or alternatively, in response to the detected clipping, controller 170 may generate control signals for low-pass filter 140 to attenuate the baseband signal such that the signal range limit is no longer exceeded, and the clipping stops.

In some embodiments, the analog-to-digital converter 160 does not detect whether the baseband signal exceeds a signal range limit.

As understood by those of skill in the art, the control signals from controller 170 may cause one or more gain elements to attenuate the blocker signal. Additionally or alternatively, as understood by those of skill in the art, the control signals from controller 170 may cause one or more filtering elements to filter the blocker signal by, for example, moving a pole of the one or more filtering elements.

Figure 2 is a schematic diagram of another embodiment of a receiver circuit 200. Receiver circuit 200 includes low noise amplifier (LNA) 210, low-pass filter (LPF) 280, mixer 220, optional buffer 230, low-pass filter (LPF) 240, variable gain amplifier (VGA) 250, analog-to-digital converter (ADC) 260, and controller 270.

Low noise amplifier 210 is configured to receive a high-frequency carrier signal modulated with a low frequency information signal as filtered by filter 280. In some embodiments, the filtering of filter 280 is sufficient, that a SAW filter (or other similar) filter is not used to filter the high-frequency carrier signal prior to its being received by receiver 200.

In some embodiments, low noise amplifier 210 includes a matching network, as understood by those of skill in the art. In some embodiments, the high-frequency carrier signal is an output of a matching network, as understood by one of skill in the art.

The received signal also includes a blocker signal, such as a high power signal also modulating the high-frequency carrier signal near the frequency of the information signal. Low noise amplifier 210 may be any low noise amplifier or amplifier, as understood by those of skill in the art.

In the illustrated embodiment, filter 280 includes capacitor C2 and switch SW2. As understood by those of skill in the art, the connection relationship between capacitor C2 and switch SW2 may be reversed, such that switch SW2 is connected to LNA 210 and capacitor C2 is connected to ground. In some embodiments, filter 280 may be a multiphase filter, such as multiphase filter 380 discussed below.

In response to the output from the low noise amplifier 210 and low-pass filter 280, and in response to control signals from controller 270, mixer 220 down converts the signal from the low noise amplifier 210 and low-pass filter 280. In some embodiments, the resulting initial baseband signal includes information of the low frequency information signal and of the blocker signal.

The baseband signal may then be processed by optional buffer 230. Because of the blocker signal, signals at the optional buffer 230 may exceed an input or output range limit, such that signals at the input, the output, or internal to the optional buffer 230 experience clipping. Not being part of the present invention, using techniques known to those of skill in the art, the clipping may be detected, and communicated to controller 270. In response to the detected clipping, controller 270 may generate control signals for optional buffer 230 to attenuate the baseband signal such that the signal range limit is no longer exceeded, and the clipping stops. Additionally or alternatively, in response to the detected clipping, controller 270 may generate control signals for low-pass filter 280 which cause low-pass filter 280 to attenuate the baseband signal such that the signal range limit is no longer exceeded, and the clipping stops.

In some embodiments, the optional buffer 230 does not detect whether the baseband signal exceeds a signal range limit.

The baseband signal is then processed by the low-pass filter 240. Because of the blocker signal, signals at the low-pass filter 240 may exceed an input or output range limit, such that signals at the input, the output, or internal to the low-pass filter 240 experience clipping. Not being part of the present invention, using techniques known to those of skill in the art, the clipping may be detected, and communicated to controller 270. In response to the detected clipping, controller 270 may generate control signals for low-pass filter 240 to attenuate the baseband signal such that the signal range limit is no longer exceeded, and the clipping stops. Additionally or alternatively, in response to the detected clipping, controller 270 may generate control signals for optional buffer 230 to attenuate the baseband signal such that the signal range limit is no longer exceeded, and the clipping stops. Additionally or alternatively, in response to the detected clipping, controller 270 may generate control signals for low-pass filter 280 which cause low-pass filter 280 to attenuate the baseband signal such that the signal range limit is no longer exceeded, and the clipping stops.

In some embodiments, the low-pass filter 240 does not detect whether the baseband signal exceeds a signal range limit.

The baseband signal is then processed by the variable gain amplifier 250. Because of the blocker signal, signals at the variable gain amplifier 250 exceed an input or output range limit, such that signals at the input, the output, or internal to the variable gain amplifier 250 experience clipping. Using techniques known to those of skill in the art, the clipping is detected, and communicated to controller 270. In response to the detected clipping, controller 270 generates control signals for low-pass filter 280 which cause low-pass filter 280 to attenuate the baseband signal such that the signal range limit is no longer exceeded, and the clipping stops.

In some embodiments, variable gain amplifier 250 does not detect whether the baseband signal exceeds a signal range limit.

The baseband signal is then processed by the analog-to-digital converter 260. Because of the blocker signal, signals at the analog-to-digital converter 260 exceed an input or output range limit, such that signals at the input, the output, or internal to the analog-to-digital converter 260 experience clipping. Using techniques known to those of skill in the art, the clipping is detected, and communicated to controller 270. In response to the detected clipping, controller 270 generates control signal for low-pass filter 280 which cause low-pass filter 280 to attenuate the baseband signal such that the signal range limit is no longer exceeded, and the clipping stops.

In some embodiments, the analog-to-digital converter 260 does not detect whether the baseband signal exceeds a signal range limit.

As understood by those of skill in the art, the control signals from controller 270 causes one or more gain elements to attenuate the blocker signal. Additionally or alternatively, as understood by those of skill in the art, the control signals from controller 270 may cause one or more filtering elements to filter the blocker signal by, for example, moving a pole of the one or more filtering elements.

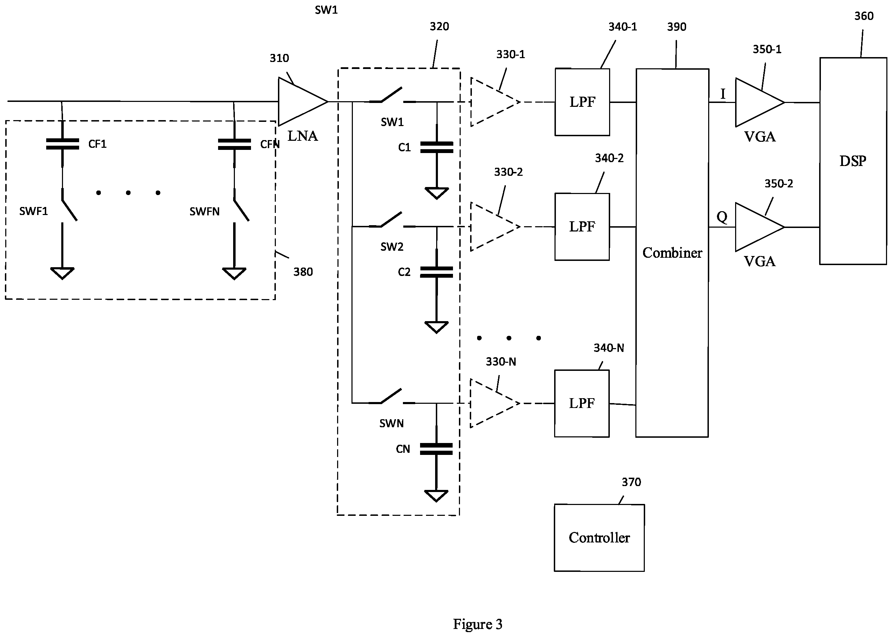

The following embodiments of Figure 3 are not according to the invention and are present for illustration purposes only. Figure 3 is a schematic diagram of yet another embodiment of a receiver circuit 300. Receiver circuit 300 includes low noise amplifier (LNA) 310, multi-phase mixer 320, optional buffers 330-1, 330-2 ... 330-N, low-pass filters (LPF) 340-1, 340-2 ... 340-N, combiner 390, variable gain amplifiers (VGA) 350-1 and 350-2, digital signal processor (DSP) 360, controller 370, and multiphase filter 380.

Low noise amplifier 310 is configured to receive a high-frequency carrier signal modulated with a low frequency information signal as filtered by filter 380. In some embodiments, the filtering of filter 380 is sufficient, that a SAW filter (or other similar) filter is not used to filter the high-frequency carrier signal prior to its being received by receiver 300.

In some embodiments, low noise amplifier 310 includes a matching network, as understood by those of skill in the art. In some embodiments, the high-frequency carrier signal is an output of a matching network, as understood by one of skill in the art.

In the illustrated embodiment, filter 380 includes capacitors CF1 - CFN and switches SWF1-SWFN. As understood by those of skill in the art, the connection relationship between capacitors CF1 - CFN and switches SWF1-SWFN such that the capacitors CF1 - CFN may be connected to ground and switches SWF1-SWFN may be connected to LNA 310. In some embodiments, filter 380 may be a single phase filter, such as single phase filter 280 discussed above.

The high-frequency carrier signal may also include a blocker signal, such as a high power signal also modulating the high-frequency carrier signal near the frequency of the information signal. Low noise amplifier 310 may be any low noise amplifier or amplifier, as understood by those of skill in the art.

In response to the output from the low noise amplifier 310, and in response to control signals from controller 370, multi-phase mixer 320 down converts the signal from the low noise amplifier 310. In some embodiments, the resulting initial baseband signals include information of the low frequency information signal and of the blocker signal.

The baseband signals may then be processed by optional buffers 330-1, 330-2 ... 330-N, which buffer the signals, as understood by those of ordinary skill in the art. Because of the blocker signal, signals at the optional buffers 330-1, 330-2 ... 330-N may exceed an input or output range limit, such that signals at the inputs, the outputs, or internal to the optional buffers 330-1, 330-2 ... 330-N experience clipping. Not being part of the present invention, using techniques known to those of skill in the art, the clipping may be detected, and communicated to controller 370. In response to the detected clipping, controller 370 may generate control signals for optional buffers 330-1, 330-2 ... 330-N to attenuate the baseband signals such that the signal range limit is no longer exceeded, and the clipping stops. Additionally or alternatively, in response to the detected clipping, controller 370 may generate control signals for multi-phase mixer 320 which cause multi-phase mixer 320 to attenuate the baseband signals such that the signal range limit is no longer exceeded, and the clipping stops. Additionally or alternatively, in response to the detected clipping, controller 370 may generate control signals for low-pass filter 380 which cause low-pass filter 380 to attenuate the baseband signal such that the signal range limit is no longer exceeded, and the clipping stops.

In some embodiments, optional buffers 330-1, 330-2 ... 330-N do not detect whether the baseband signal exceeds a signal range limit.

The baseband signals are then processed by the low-pass filters 340-1, 340-2 ... 340-N, which filter the signals, as understood by those of ordinary skill in the art. Because of the blocker signal, signals at the low-pass filters 340-1, 340-2 ... 340-N may exceed an input or output range limit, such that signals at the input, the output, or internal to the low-pass filters 340-1, 340-2 ... 340-N experience clipping. Not being part of the present invention, using techniques known to those of skill in the art, the clipping may be detected, and communicated to controller 370. In response to the detected clipping, controller 370 may generate control signals for low-pass filters 340-1, 340-2 ... 340-N to attenuate the baseband signal such that the signal range limit is no longer exceeded, and the clipping stops. Additionally or alternatively, in response to the detected clipping, controller 370 may generate control signals for optional buffers 330-1, 330-2 ... 330-N to attenuate the baseband signal such that the signal range limit is no longer exceeded, and the clipping stops. Additionally or alternatively, in response to the detected clipping, controller 370 may generate control signals for multi-phase mixer 320 which cause multi-phase mixer 320 to attenuate the baseband signals such that the signal range limit is no longer exceeded, and the clipping stops. Additionally or alternatively, in response to the detected clipping, controller 370 may generate control signals for low-pass filter 380 which cause low-pass filter 380 to attenuate the baseband signal such that the signal range limit is no longer exceeded, and the clipping stops.

In some embodiments, the low-pass filters 340-1, 340-2 ... 340-N do not detect whether the baseband signal exceeds a signal range limit.

The baseband signals are then processed by the combiner 390, which combines the signals to generate baseband I and Q signals, using techniques such as weighted harmonic rejection, as understood by those of ordinary skill in the art. Other combining techniques may be used. Because of the blocker signal, signals at the combiner 390 may exceed an input or output range limit, such that signals at the input, the output, or internal to the combiner 390 experience clipping. Not being part of the present invention, using techniques known to those of skill in the art, the clipping may be detected, and communicated to controller 370. In response to the detected clipping, controller 370 may generate control signals for combiner 390 to attenuate the baseband signal such that the signal range limit is no longer exceeded, and the clipping stops. Additionally or alternatively, in response to the detected clipping, controller 370 may generate control signals for low-pass filters 340-1, 340-2 ... 340-N to attenuate the baseband signal such that the signal range limit is no longer exceeded, and the clipping stops. Additionally or alternatively, in response to the detected clipping, controller 370 may generate control signals for optional buffers 330-1, 330-2 ... 330-N to attenuate the baseband signal such that the signal range limit is no longer exceeded, and the clipping stops. Additionally or alternatively, in response to the detected clipping, controller 370 may generate control signals for multi-phase mixer 320 which cause multi-phase mixer 320 to attenuate the baseband signals such that the signal range limit is no longer exceeded, and the clipping stops. Additionally or alternatively, in response to the detected clipping, controller 370 may generate control signals for low-pass filter 380 which cause low-pass filter 380 to attenuate the high-frequency carrier signal such that the signal range limit is no longer exceeded, and the clipping stops.

In some embodiments, using circuitry understood by those of skill in the art, the functionality of low-pass filters 340-1, 340-2 ... 340-N may be included in combiner 390, such that a low-pass filter/combiner circuit receives baseband signals from either the multi-phase mixer 320 or the optional buffers 330-1, 330-2 ... 330-N, and both filters the baseband signals, and generates corresponding I and Q signals.

The baseband I and Q signals are then processed by the variable gain amplifiers 350-1 and 350-2. Because of the blocker signal, signals at the variable gain amplifiers 350-1 and 350-2 may exceed an input or output range limit, such that signals at the input, the output, or internal to the variable gain amplifiers 350-1 and 350-2 experience clipping. Using techniques known to those of skill in the art, the clipping may be detected, and communicated to controller 370. In response to the detected clipping, controller 370 may generate control signals for variable gain amplifiers 350-1 and 350-2 to attenuate the baseband signal such that the signal range limit is no longer exceeded, and the clipping stops. Additionally or alternatively, in response to the detected clipping, controller 370 may generate control signals for combiner 390 to attenuate the baseband signal such that the signal range limit is no longer exceeded, and the clipping stops. Additionally or alternatively, in response to the detected clipping, controller 370 may generate control signals for low-pass filters 340-1, 340-2 ... 340-N to attenuate the baseband signal such that the signal range limit is no longer exceeded, and the clipping stops. Additionally or alternatively, in response to the detected clipping, controller 370 may generate control signals for optional buffers 330-1, 330-2 ... 330-N to attenuate the baseband signal such that the signal range limit is no longer exceeded, and the clipping stops. Additionally or alternatively, in response to the detected clipping, controller 370 may generate control signals for multi-phase mixer 320 which cause multi-phase mixer 320 to attenuate the baseband signals such that the signal range limit is no longer exceeded, and the clipping stops. Additionally or alternatively, in response to the detected clipping, controller 370 may generate control signals for low-pass filter 380 which cause low-pass filter 380 to attenuate the baseband signal such that the signal range limit is no longer exceeded, and the clipping stops.

In some embodiments, variable gain amplifiers 350-1 and 350-2 do not detect whether the baseband signal exceeds a signal range limit.

The baseband signals are then processed by the digital signal processor 360. Because of the blocker signal, signals at the digital signal processor 360 may exceed an input or output range limit, such that signals at the input, the output, or internal to the digital signal processor 360 experience clipping. Using techniques known to those of skill in the art, the clipping may be detected, and communicated to controller 370. In response to the detected clipping, controller 370 may generate control signals for digital signal processor 360 to attenuate the baseband signal such that the signal range limit is no longer exceeded, and the clipping stops. Additionally or alternatively, in response to the detected clipping, controller 370 may generate control signals for variable gain amplifiers 350-1 and 350-2 to attenuate the baseband signal such that the signal range limit is no longer exceeded, and the clipping stops. Additionally or alternatively, in response to the detected clipping, controller 370 may generate control signals for low-pass filters 340-1, 340-2 ... 340-N to attenuate the baseband signal such that the signal range limit is no longer exceeded, and the clipping stops. Additionally or alternatively, in response to the detected clipping, controller 370 may generate control signals for optional buffers 330-1, 330-2 ... 330-N to attenuate the baseband signal such that the signal range limit is no longer exceeded, and the clipping stops. Additionally or alternatively, in response to the detected clipping, controller 370 may generate control signals for multi-phase mixer 320 which cause multi-phase mixer 320 to attenuate the baseband signals such that the signal range limit is no longer exceeded, and the clipping stops. Additionally or alternatively, in response to the detected clipping, controller 370 may generate control signals for low-pass filter 380 which cause low-pass filter 380 to attenuate the baseband signal such that the signal range limit is no longer exceeded, and the clipping stops.

In some embodiments, the digital signal processor 360 does not detect whether the baseband signal exceeds a signal range limit.

As understood by those of skill in the art, the control signals from controller 370 may cause one or more gain elements to attenuate the blocker signal. Additionally or alternatively, as understood by those of skill in the art, the control signals from controller 370 may cause one or more filtering elements to filter the blocker signal by, for example, moving a pole of the one or more filtering elements.

## Claims

1. A receiver circuit (200), comprising:
an amplifier (210) configured to generate an RF signal based on a received signal, wherein the RF signal comprises an information signal and a blocker signal modulating an RF carrier frequency;
a single phase mixer (220) connected to the amplifier (210), wherein the single phase mixer (220) is configured to receive the RF signal and to downconvert the RF signal to a baseband signal, wherein the baseband signal comprises the information signal and the blocker signal modulating a baseband carrier frequency, and wherein the baseband carrier frequency is less than the RF carrier frequency;
an RF filter (280) connected to the amplifier (210), wherein the RF filter (280) is configured to attenuate the blocker signal in response to a control signal generated by a controller (270);
wherein the receiver circuit (200) further comprises a variable gain amplifier (250) configured to process the baseband signal, the controller (270) is configured to generate the control signal in response to the input or output signals at the variable gain amplifier (250) which exceeds an input or output range limit of the variable gain amplifier (250) for the RF filter (280), wherein, in response to the control signals, the RF filter (280) is configured to attenuate the blocker signal; or
wherein the receiver circuit (200) comprises an analog-to-digital converter (260) configured to process the baseband signal, and the controller (270) is configured to generate the control signal in response to the input or output signals at the analog-to-digital converter (260) which exceeds an input or output range limit of the analog-to-digital converter (260) for the RF filter (280), wherein, in response to the control signals, the RF filter (280) is configured to attenuate the blocker signal.

2. The receiver circuit (200) of claim 1, wherein the RF filter (280) comprises a capacitor (C2) having a terminal connected to or selectively connected to an input of the amplifier (210) configured to receive the received signal.

3. The receiver circuit (200) of claim 2, wherein the RF filter (280) comprises a switch (SW2) connected to ground or the amplifier (210).

4. A method of operating a receiver circuit (200), the receiver circuit comprising:
an amplifier (210); and
an RF filter (280) connected to the amplifier (210),
a single phase mixer (220) connected to the amplifier (210),
the method comprising:
with the amplifier (210), generating an RF signal based on a received signal, wherein the RF signal comprises an information signal and a blocker signal modulating an RF carrier frequency;
with the single phase mixer (220), receiving the RF signal and downconverting the RF signal to a baseband signal, wherein the baseband signal comprises the information signal and the blocker signal modulating a baseband carrier frequency, and wherein the baseband carrier frequency is less than the RF carrier frequency;
with the RF filter (280), attenuating the blocker signal in response to a control signal generated by a controller (270);
wherein the receiver circuit (200) further comprises a variable gain amplifier (250) or an analog-to-digital converter (260), and wherein the method further comprises:
with the variable gain amplifier (250), processing the baseband signal, with the controller (270), generating the control signal in response to the input or output signals at the variable gain amplifier (250) which exceeds an input or output range limit of the variable gain amplifier (250) for the RF filter (280), and with the RF filter (280), in response to the control signals, attenuating the blocker signal; or
with the analog-to-digital converter (260), processing the baseband signal, with the controller (270), generating the control signal the control signal in response to the input or output signals at the analog-to-digital converter (260) which exceeds an input or output range limit of the analog-to-digital converter (260) for the RF filter (280), and with the RF filter (280), in response to the controlling signals, attenuating the blocker signal.

5. The method of claim 4, wherein the RF filter comprises a capacitor (C2) having a terminal connected to or selectively connected to an input of the amplifier (210) configured to receive the received signal.

6. The method of claim 5, wherein the RF filter (280) comprises a switch (SW2) connected to ground or the amplifier (210).

## Patentansprüche

1. Empfängerschaltung (200), die Folgendes umfasst:
einen Verstärker (210), der konfiguriert ist, basierend auf einem empfangenen Signal ein RF-Signal zu erzeugen, wobei das RF-Signal ein Informationssignal und ein Blockierersignal, die eine RF-Trägerfrequenz modulieren, umfasst;
einen Einphasenmischer (220), der mit dem Verstärker (210) verbunden ist, wobei der Einphasenmischer (220) konfiguriert ist, das RF-Signal zu empfangen und das RF-Signal in ein Basisbandsignal abwärts umzusetzen, wobei das Basisbandsignal das Informationssignal und das Blockierersignal, die eine Basisbandsignalträgerfrequenz modulieren, umfasst, und wobei die Basisbandträgerfrequenz kleiner ist als die RF-Trägerfrequenz;
ein RF-Filter (280), das mit dem Verstärker (210) verbunden ist, wobei das RF-Filter (280) konfiguriert ist, das Blockierersignal als Antwort auf ein Steuersignal, das von einer Steuereinrichtung (270) erzeugt wird, zu dämpfen;
wobei die Empfängerschaltung (200) ferner einen Verstärker (250) mit variabler Verstärkung umfasst, der konfiguriert ist, das Basisband zu bearbeiten, wobei die Steuereinrichtung (270) konfiguriert ist, als Antwort auf das Eingangs- oder das Ausgangssignal an dem Verstärker (250) mit variabler Verstärkung, das eine Eingangs- oder Ausgangsbereichsgrenze des Verstärkers (250) mit variabler Verstärkung überschreitet, das Steuersignal für das RF-Filter (280) zu erzeugen, wobei das RF-Filter (280) konfiguriert ist, als Antwort auf die Steuersignale das Blockierersignal zu dämpfen; oder
wobei die Empfängerschaltung (200) einen Analog/DigitalUmsetzer (260) umfasst, der konfiguriert ist, das Basisbandsignal zu bearbeiten, und die Steuereinrichtung (270) konfiguriert ist, als Antwort auf das Eingangs- oder das Ausgangssignal an dem Analog/Digital-Umsetzer (260), das eine Eingangs- oder Ausgangsbereichsgrenze des Analog/Digital-Umsetzers (260) überschreitet, das Steuersignal für das RF-Filter (280) zu erzeugen, wobei das RF-Filter (280) konfiguriert ist, als Antwort auf die Steuersignale das Blockierersignal zu dämpfen.

2. Empfängerschaltung (200) nach Anspruch 1, wobei das RF-Filter (280) einen Kondensator (C2) umfasst, der einen Anschluss aufweist, der mit einem Eingang des Verstärkers (210) verbunden oder selektiv verbunden ist und der konfiguriert ist, das empfangene Signal zu empfangen.

3. Empfängerschaltung (200) nach Anspruch 2, wobei das RF-Filter (280) einen Schalter (SW2) umfasst, der mit Masse oder dem Verstärker (210) verbunden ist.

4. Verfahren zum Betreiben einer Empfängerschaltung (200), wobei die Empfängerschaltung Folgendes umfasst:
einen Verstärker (210); und
ein RF-Filter (280), das mit dem Verstärker (210) verbunden ist,
einen Einphasenmischer (220), der mit dem Verstärker (210) verbunden ist,
wobei das Verfahren Folgendes umfasst:
mit dem Verstärker (210) Erzeugen eines RF-Signals basierend auf einem empfangenen Signal, wobei das RF-Signal ein Informationssignal und ein Blockierersignal, die eine RF-Trägerfrequenz modulieren, umfasst;
mit dem Einphasenmischer (220) Empfangen des RF-Signals und Abwärtsumsetzen des RF-Signals in ein Basisbandsignal, wobei das Basisbandsignal das Informationssignal und das Blockierersignal, die eine Basisbandträgerfrequenz modulieren, umfasst und wobei die Basisbandträgerfrequenz kleiner ist als die RF-Trägerfrequenz;
mit dem RF-Filter (280) Dämpfen des Blockierersignals als Antwort auf ein Steuersignal, das von einer Steuereinrichtung (270) erzeugt wird;
wobei die Empfängerschaltung (200) ferner einen Verstärker (250) mit variabler Verstärkung oder einen Analog/DigitalUmsetzer (260) umfasst und wobei das Verfahren ferner Folgendes umfasst:
mit dem Verstärker (250) mit variabler Verstärkung, Bearbeiten des Basisbandsignals, mit der Steuereinrichtung (270) Erzeugen des Steuersignals für das RF-Filter (280) als Antwort auf das Eingangs- oder Ausgangssignal an dem Verstärker (250) mit variabler Verstärkung, das eine Eingangs- oder Ausgangsbereichsgrenze des Verstärkers (250) mit variabler Verstärkung überschreitet, und mit dem RF-Filter (280) als Antwort auf die Steuersignale Dämpfen des Blockierersignals; oder
mit dem Analog/Digital-Umsetzer (260) Bearbeiten des Basisbandsignals, mit der Steuereinrichtung (270) Erzeugen des Steuersignals für das RF-Filter (280) als Antwort auf das Eingangs- oder Ausgangssignal an dem Analog/DigitalUmsetzer (260), das eine Eingangs- oder Ausgangsbereichsgrenze des Analog/Digital-Umsetzers (260) überschreitet, und mit dem RF-Filter (280) als Antwort auf die Steuersignale Dämpfen des Blockierersignals.

5. Verfahren nach Anspruch 4, wobei das RF-Filter einen Kondensator (C2) umfasst, der einen Anschluss aufweist, der mit einem Eingang des Verstärkers (210) verbunden oder selektiv verbunden ist und der konfiguriert ist, das empfangene Signal zu empfangen.

6. Verfahren nach Anspruch 5, wobei das RF-Filter (280) einen Schalter (SW2) umfasst, der mit Masse oder dem Verstärker (210) verbunden ist.

## Revendications

1. Circuit récepteur (200), comprenant :
un amplificateur (210) configuré de façon à générer un signal RF en se basant sur un signal reçu, lgnal de blocage modulant une fréquence porteuse RF ;
un mélangeur monophasé (220) connecté à l'amplificateur (210), le mélangeur monophasé (220) étant configuré de façon à recevoir le signal RF et à abaisser la fréquence du signal RF pour le convertir en un signal de bande de base, le signal de bande de base comprenant le signal d'information et le signal de blocage modulant une fréquence porteuse de bande de base, et la fréquence porteuse de bande de base étant plus basse que la fréquence porteuse RF ;
un filtre RF (280) connecté à l'amplificateur (210), le filtre RF (280) étant configuré de façon à atténuer le signal de blocage en réponse à un signal de commande généré par un contrôleur (270) ;
le circuit récepteur (200) comprenant en outre une amplificateur à gain variable (250) configuré de façon à traiter le signal de bande de base, le contrôleur (270) étant configuré de façon à générer le signal de commande en réponse aux signaux d'entrée ou de sortie au niveau de l'amplificateur à gain variable (250) qui dépassent une limite de plage d'entrée ou de sortie de l'amplificateur à gain variable (250) pour le filtre RF (280), le filtre RF (280) étant configuré de façon à atténuer le signal de blocage en réponse aux signaux de commande ; ou
le circuit récepteur (200) comprenant un convertisseur analogique-numérique (260) configuré de façon à traiter le signal de bande de base, et le contrôleur (270) étant configuré de façon à générer le signal de commande en réponse aux signaux d'entrée ou de sortie au niveau du convertisseur analogique-numérique (260) qui dépassent une limite de plage d'entrée ou de sortie du convertisseur analogique-numérique (260) pour le filtre RF (280), le filtre RF (280) étant configuré de façon à atténuer le signal de blocage en réponse aux signaux de commande.

2. Circuit récepteur (200) selon la revendication 1, dans lequel le filtre RF (280) comporte un condensateur (C2) ayant une borne connectée à ou connectée sélectivement à une entrée de l'amplificateur (210) configuré de façon à recevoir le signal reçu.

3. Circuit récepteur (200) selon la revendication 2, dans lequel le filtre RF (280) comporte un commutateur (SW2) connecté à la masse ou à l'amplificateur (210).

4. Procédé d'utilisation d'un circuit récepteur (200), le circuit récepteur comprenant :
un amplificateur (210) ; et
un filtre RF (280) connecté à l'amplificateur (210),
un mélangeur monophasé (220) connecté à l'amplificateur (210),
le procédé comprenant :
avec l'amplificateur (210), la génération d'un signal RF en se basant sur un signal reçu, le signal RF comprenant un signal d'information et un signal de blocage modulant une fréquence porteuse RF ;
avec le mélangeur monophasé (220), la réception du signal RF et l'abaissement de la fréquence du signal RF pour le convertir en un signal de bande de base, le signal de bande de base comprenant le signal d'information et le signal de blocage modulant une fréquence porteuse de bande de base, et la fréquence porteuse de bande de base étant plus basse que la fréquence porteuse RF ;
avec le filtre RF (280), l'atténuation du signal de blocage en réponse à un signal de commande généré par le contrôleur (270) ;
le circuit récepteur (200) comprenant en outre un amplificateur à gain variable (250) ou un convertisseur analogique-numérique (260), et le procédé comprenant en outre :
avec l'amplificateur à gain variable (250), le traitement du signal de bande de base, avec le contrôleur (270), la génération du signal de commande en réponse aux signaux d'entrée ou de sortie au niveau de l'amplificateur à gain variable (250) qui dépassent une limite de plage d'entrée ou de sortie de l'amplificateur à gain variable (250) pour le filtre RF (280), et avec le filtre RF (280), l'atténuation du signal de blocage en réponse aux signaux de commande ; ou
avec le convertisseur analogique-numérique (260), le traitement du signal de bande de base, avec le contrôleur (270), la génération du signal de commande en réponse aux signaux d'entrée ou de sortie au niveau du convertisseur analogique-numérique (260) qui dépassent une limite de plage d'entrée ou de sortie du convertisseur analogique-numérique (260) pour le filtre RF (280), et avec le filtre RF (280), l'atténuation du signal de blocage en réponse aux signaux de commande.

5. Procédé selon la revendication 4, dans lequel le filtre RF comporte un condensateur (C2) ayant une borne connectée à ou connectée sélectivement à une entrée de l'amplificateur (210) configuré de façon à recevoir le signal reçu.

6. Procédé selon la revendication 5, dans lequel le filtre RF (280) comporte un commutateur (SW2) connecté à la masse ou à l'amplificateur (210).
